(19) Europäisches Patentamt
European Patent Office
Office européen des brevets

(11) **EP 2 832 785 A1**

(12) **EUROPEAN PATENT APPLICATION**

(43) Date of publication:
**04.02.2015 Bulletin 2015/06**

(51) Int Cl.:
***C08K 3/08*** *(2006.01)*    ***G02F 1/1343*** *(2006.01)*
***G02B 5/30*** *(2006.01)*    ***H01B 1/22*** *(2006.01)*

(21) Application number: **14179164.0**

(22) Date of filing: **30.07.2014**

| | |
|---|---|
| (84) Designated Contracting States:<br>**AL AT BE BG CH CY CZ DE DK EE ES FI FR GB GR HR HU IE IS IT LI LT LU LV MC MK MT NL NO PL PT RO RS SE SI SK SM TR**<br>Designated Extension States:<br>**BA ME**<br><br>(30) Priority: **31.07.2013  KR 20130091230**<br><br>(71) Applicant: **Samsung SDI Co., Ltd.**<br>**Gyeonggi-do 446-902 (KR)**<br><br>(72) Inventors:<br>• **Kim, Do Young**<br>**Uiwang-si, Gyeonggi-do (KR)** | • **Kang, Kyoung Ku**<br>**Uiwang-si, Gyeonggi-do (KR)**<br>• **Koo, Young Kwon**<br>**Uiwang-si, Gyeonggi-do (KR)**<br>• **Shin, Dong Myeong**<br>**Uiwang-si, Gyeonggi-do (KR)**<br>• **Lim, Hyoung Tae**<br>**Uiwang-si, Gyeonggi-do (KR)**<br>• **Hwang, Oh Hyeon**<br>**Uiwang-si, Gyeonggi-do (KR)**<br><br>(74) Representative: **Michalski Hüttermann & Partner**<br>**Patentanwälte mbB**<br>**Speditionstraße 21**<br>**40221 Düsseldorf (DE)** |

(54) **Transparent conductor and optical display apparatus comprising the same**

(57)    A transparent conductor and an optical display apparatus comprising the same are disclosed. More specifically, a transparent conductor comprising a base layer, and a transparent conductive film formed on one or both sides of the base layer, the transparent conductive film comprising a metal nanowire, wherein the base layer is a retardation film; and an optical display apparatus comprising the same are disclosed.

**FIG. 1**

**Description**

**Field of the Invention**

The present invention relates to a transparent conductor and an optical display apparatus comprising the same.

**Description of the Related Art**

Transparent conductors have been used in a wide variety of applications including touch screen panels, flexible displays and the like for display devices, and thus actively studied in recent years. The transparent conductors need to have not only good basic properties in terms of transparency, sheet resistance, *etc.,* but also a bending property to satisfy the requirements for expanded applications up to flexible displays. Recently, a transparent conductor, in which a conductive layer including metal nanowires such as silver nanowires and the like is formed, has been developed. Such a transparent conductor has an advantage of good bending property. When used in displays, contrast ratio of a general transparent conductor varies with angles at which observers view the displays. Also a general transparent conductor has a poor viewing angles result of retardation in the course of passing through liquid crystals.

**Summary of the Invention**

A transparent conductor of the present invention may include a base layer; and a transparent conductive film formed on one or both sides of the base layer, the transparent conductive film comprising a metal nanowire, wherein the base layer may be a retardation film.
An optical display apparatus of the present invention may include the transparent conductor.

**Brief description of the Drawings**

Fig. 1 illustrates a cross-sectional view of a transparent conductor according to one embodiment of the present invention.
Fig. 2 illustrates a cross-sectional view of a transparent conductor according to another embodiment of the present invention.
Fig. 3 illustrates a cross-sectional view of a transparent conductor according to other embodiment of the present invention.
Fig. 4 illustrates a conceptual diagram of a transparent conductor according to one embodiment of the present invention.
Fig. 5 illustrates a cross-sectional view of an optical display apparatus according to one embodiment of the present invention.
Fig. 6 illustrates a cross-sectional view of an optical display apparatus according to another embodiment of the present invention.
Fig. 7 illustrates a cross-sectional view of an optical display apparatus according to a further embodiment of the present invention.

**Detailed description of the Invention**

Certain embodiments of the present invention will now be described in more detail such that they may easily have been made by a person with ordinary skill in the art with reference to the accompanying drawings. The present invention may be modified in different ways and is not limited to the following embodiments. In the drawings, elements irrelevant to the description of embodiments of the present invention will be omitted for clarity. The same reference numerals will be used throughout the drawings and the description to refer to the same or similar parts. As used herein, terms such as "upper side" and "lower side" are defined with reference to the accompanying drawings. Thus, it will be understood that the term "upper side" may be used interchangeably with the term "lower side" when viewed from different angles.
In this application, "Ro" means "a retardation value of In-plane direction" and may be defined by Formula 1:

[Formula 1]

$$Ro = (nx - ny) \times d$$

wherein Formula 1, nx and ny are refractive indexes in the x-axis of a film and in the y-axis of a film, respectively, and d is a thickness of a film in nm.

In this application, "Rth" means "a retardation value of thickness direction" and may be defined by Formula 2:

[Formula 2]

$$Rth = ((nx + ny)/2 - nz) \times d$$

wherein Formula 2, nx, ny, and nz are refractive indexes in the x-axis of a film, in the y-axis of a film, and in the z-axis of a film, respectively, and d is a thickness of a film in nm.

In embodiments of the present application, refractive indexes represented by nx, ny or nz, may be measured by using AxoScan(Axometrics, Inc.) at each wavelength 450nm, 550nm and 650nm.

In this application, the "(meth)acryl" may mean an acryl and/or a methacryl.

A transparent conductor according to embodiments of the present invention may include a base layer; and a transparent conductive film formed on one or both sides of the base layer. The base layer may be a retardation film, thus the transparent conductor of the present invention may have an effect of compensating viewing angles.

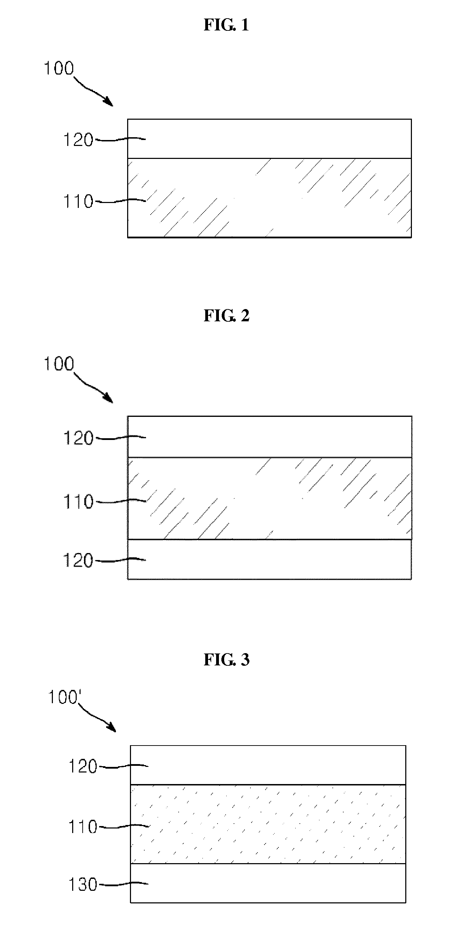

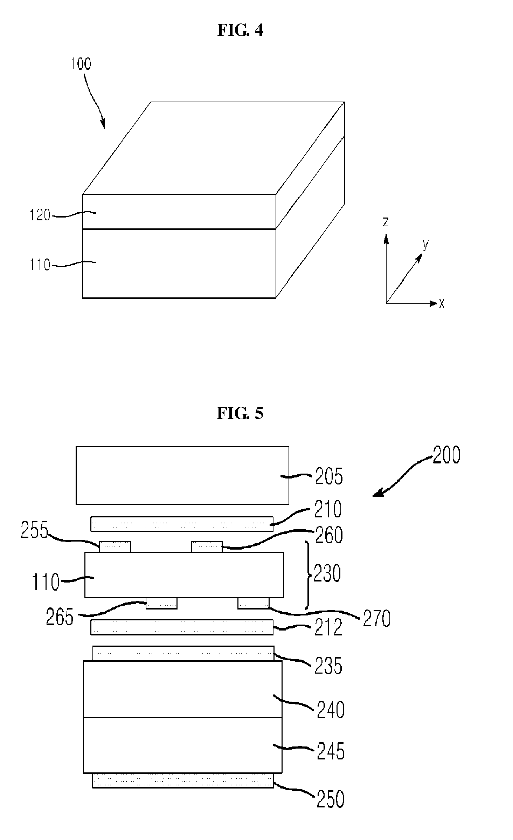

Hereinafter, embodiments of the present invention will be described with reference to Fig. 1 and Fig.4.

Fig. 1 illustrates a cross-sectional view of a transparent conductor according to one embodiment of the present invention. And Fig. 4 illustrates a conceptual diagram of a transparent conductor according to one embodiment of the present invention. Referring to Fig. 4, the direction of a x-axis of a transparent conductor 100 according to one embodiment of the present invention is the same as a machine direction MD of a base layer 110, the direction of a y-axis is the same as a transverse direction TD of the base layer 110, and the direction of a z-axis is the same as a thickness direction of the base layer 110. In Fig. 4, the x-axis, y-axis and z-axis are orthogonal each other. Although Fig. 4 illustrates a transparent conductor having a transparent conductive film formed on one side thereof, it is also applied to a transparent conductor having a transparent conductive film formed on both sides thereof.

Referring to Fig. 1, according to one embodiment of the present invention, a transparent conductor 100 may include a base layer 110; and a first transparent conductive film 120 formed on the base layer 110. The base layer 110 may be a retardation film, so that the transparent conductor 100 may compensate retardation as a result of a good wavelength dispersion.

In one embodiment, the transparent conductor 100 itself compensates a λ/2 or λ/4 retardation. For example, the transparent conductor 100 may have a Ro value of 120 nm to 150 nm or 120 nm to 135 nm at a wavelength of 450 nm. And Ro value of the transparent conductor 100 may be 135 nm to 155 nm or 140 nm to 150 nm at a wavelength of 550 nm. And, Ro value of the transparent conductor 100 may be 130 nm to 155 nm or 145 nm to 155 nm at a wavelength of 650 nm.

In one embodiment, the transparent conductor 100 may have a Rth value of 50 nm to 70 nm at a wavelength of 450 nm. And Rth value of the transparent conductor 100 may be 50 nm to 80 nm or 65 nm to 75 nm at a wavelength of 550 nm. And, Rth value of the transparent conductor 100 may be 50 nm to 80 nm or 65 nm to 75 nm at a wavelength of 650 nm.

In one embodiment, the transparent conductor 100 may have a nx value of 1.50 nm to 1.65 nm at a wavelength each of 450 nm, 550 nm or 650 nm. And ny value of the transparent conductor 100 may be 1.50 nm to 1.65 nm at a wavelength each of 450 nm, 550 nm or 650 nm. And, nz value of the transparent conductor 100 may be 1.50 nm to 1.65 nm at a wavelength each of 450 nm, 550 nm or 650 nm.

In one embodiment, a transparent conductor 100 may have a B/A of 0.9 to 1.1, the B/A being a ratio of a Ro value B in nm at a wavelength of 450 nm to a Ro value A in nm at a wavelength of 550 nm. Within this range of B/A, an improved viewing angle and an enhanced visibility may be achieved. For example, B/A may be 0.9 to 1.06.

In another embodiment, the transparent conductor 100 may have a C/A of 0.9 to 1.1, the C/A being a ratio of a Ro value C in nm at a wavelength of 650 nm to a Ro value A in nm at a wavelength of 550 nm. Within this range of C/A, an improved viewing angle and an enhanced visibility may be achieved. For example, C/A may be 1.001 to 1.1.

The transparent conductor 100 may exhibit transparency in the range of visible light, for example, at a wavelength of 400 nm to 700 nm. In one embodiment, the transparent conductor 100 may have a haze value of 0% to 1.5%, for example, 0.01% to 1.5%, and a total transmittance of 90% or more to 100% or less, for example, 90% to 95%, as measured using a haze meter at a wavelength of 400 nm to 700 nm. Within the ranges, the transparent conductor may exhibit good transparency andmay be used as a transparent conductor.

The transparent conductor 100 may have a sheet resistance of 150 ($\Omega/\square$) or less, for example, 50 ($\Omega/\square$) to 150 ($\Omega/\square$), or 30 ($\Omega/\square$) to 100 ($\Omega/\square$), as measured using a 4-Pin probe. Within the ranges, due to the low sheet resistance, the transparent conductor may be used as an electrode film for touch panels, andmay be applied to large touch panels.

The transparent conductor 100 may have a thickness, without limitation, of 10 $\mu$m to 250 $\mu$m, for example, 50 $\mu$m to 150 $\mu$m. Within the ranges, the transparent conductor may be used as a transparent electrode film such as a transparent electrode film for touch panels including flexible touch panels.

The transparent conductor 100 may be used as a transparent electrode film for apparatus such as touch panels, E-papers, or solar cells.

The base layer 110 may be a retardation film, and the transparent conductor may have an effect of compensating viewing angles. In one embodiment, the base layer may be a $\lambda/2$ or $\lambda/4$ retardation film.

In one embodiment, the base layer may have a *Ro* value of 120 nm to 150 nm or 125 nm to 140 nm at a wavelength of 450 nm. And *Ro* value of the base layer may be 50 nm to 280 nm, 50 nm to 200 nm, 250 nm to 280 nm, 130 nm to 155 nm or 140 nm to 150 nm at a wavelength of 550 nm. And, *Ro* value of base layer 100 may be 130 nm to 155 nm or 145 nm to 155 nm at a wavelength of 650 nm.

In one embodiment, the base layer may have a *Rth* value of 50 nm to 70 nm or 55 nm to 65 nm at a wavelength of 450 nm. And *Rth* value of the base layer may be 30 nm to 200 nm, 30 nm to 80 nm, 60 nm to 80 nm or 65 nm to 75 nm at a wavelength of 550 nm. And, *Rth* value of the base layer may be 60 nm to 90 nm or 73 nm to 85 nm at a wavelength of 650 nm.

In one embodiment, the base layer may have a *nx* value of 1.50 nm to 1.65 nm at a wavelength each of 450 nm, 550 nm or 650 nm. And *ny* value of the base layer may be 1.50 nm to 1.65 nm at a wavelength each of 450 nm, 550 nm or 650 nm. And, *nz* value of the base layer may be 1.50 nm to 1.65 nm at a wavelength each of 450 nm, 550 nm or 650 nm.

In one implement, the base layer may be a $\lambda/2$ retardation film, which may have a retardation value of In-plane direction *(Ro)* of 250 nm to 280 nm, and a retardation value of the thickness-direction *(Rth)* of 50 nm to 200 nm, at a wavelength of 550 nm. In another implement, the base layer may be a $\lambda/4$ retardation film, which may have a retardation value of In-plane direction *(Ro)* of 130 nm to 150 nm, and a retardation value of the thickness-direction (*Rth*) of 30 nm to 80 nm, at a wavelength of 550 nm.

In one implement, the base layer may be a Retardation PC film, which may have *nx* value of 1.50 nm to 1.65 nm, *ny* value of 1.50 nm to 1.65 nm, *nz* value of 1.50 nm to 1.65 nm at each wavelength of 450 nm, 550 nm or 650 nm. In another implement, the base layer may be a Retardation COP film, which may have *nx* value of 1.55 nm to 1.65 nm, *ny* value of 1.55 nm to 1.65 nm, *nz* value of 1.55 nm to 1.65 nm at each wavelength of 450 nm, 550 nm or 650 nm.

The base layer 110 may be a film with transparency. In one embodiment, the base layer may have a film having a transmittance of 85% to 100%, for example, 90% to 99% at a wavelength of 550 nm.

The base layer 110 may include a film formed with optical transparent resin, but not limited to, polycarbonate, cyclic olefin, polyester, non-cyclic polyolefin, polysulfone, polyimide, silicone, polystyrene, polyacryl, or polyvinyl chloride resin films. The polyester may include e.g., polyethylene terephthalate (PET), polyethylene naphthalate or the like.

The base layer 110 may be a single layer resin film or be laminates having two or more resin films stacked.

The base layer may 110 have a thickness of 10 $\mu$m to 200 $\mu$m, for example, 50 $\mu$m to 150 $\mu$m. Within the ranges, the transparent conductor may provide an effect of compensating viewing angles when used in displays.

As not shown in Fig 1, functional layers may be further stacked on one or both sides of the base layer 110. The functional layers include one or more of a hard coating layer, an anti-corrosive layer, an anti-glare coating layer, an adhesion promoter, a coating layer for preventing the elution of an oligomer, or the like, but not limited thereto.

The first transparent conductive film 120 may be a conductive layer including a conductive network formed from metal nanowires. As a result, the first transparent conductive film 120 may exhibit conductivities, and provide an excellent flexibility and bending properties. As such, the transparent conductive film may form electrodes by a patterning method including etching or the like to secure the flexibility, and thus may be used in flexible devices.

The first transparent conductive film 120 may include a matrix; and a conductive network of the metal nanowires impregnated in the matrix. The matrix may increase an adhesion of the base layer 110 to the first transparent conductive film 120 and a solvent resistance, and prevent an exposure of the metal nanowires to prevent an oxidation. The matrix may be formed with a composition comprising a binder and an initiator. In one embodiment, the first transparent conductive film may include 13 wt% to 23 wt% of the metal nanowires, and 77 wt% to 87 wt% of the matrix. Within the ranges, the transparent conductive film may secure the conductivity, and its increased adhesion to the base layer may be expected.

In one embodiment, the first transparent conductive film 120 may include a metal nanowire layer comprising a cured product of the metal nanowire, the binder and the initiator, and an overcoat layer comprising a cured product of the binder and the initiator on the metal nanowire layer. The first transparent conductive film 120 may be prepared by coating and drying a metal nanowire layer composition comprising the metal nanowire, solvents, the binder and an additive *(e.g.,* thickeners, *etc.)* on the base layer to form a coating layer of a metal nanowire network (e.g., a wet thin coating layer), and coating and curing a overcoat layer composition comprising the binder, solvents and the initiator on the coating layer. When the overcoat layer composition is coated, it may permeate and fill an empty space of the metal nanowire network, and may be then cured to form the matrix of the first transparent conductive film. In the first transparent conductive film, the overcoat layer is formed on the metal nanowire layer to prevent the oxidation of the metal nanowire. It is possible to stack any laminate stably on the first transparent conductive film by decreasing the roughness of a surface of the metal nanowire layer. The metal nanowire layer may be formed on and incorporated into the overcoat layer. The term "incorporated" means that the metal nanowire layer and the overcoat layer are not bonded each other by an adhesive layer and so on, and do not have an independently separable form.

In another embodiment, the first transparent conductive film 120 may include a metal nanowire layer comprising a cured product of a metal nanowire, a binder and an initiator, and may be prepared by coating and curing the first transparent conductive film composition comprising the metal nanowire, the binder, the initiator, additives (e.g., thickeners, dispersants, *etc.*) and solvents on the base layer.

The metal nanowire has much better dispersibility than a metal nanoparticle due to the shape of the nanowire. Furthermore, due to the difference in shapes between the particle and the nanowire, the metal nanowire may reduce significantly a sheet resistance of the first transparent conductive film.

The metal nanowire may have an ultrafine line shape having a specific cross-section.

In one embodiment, the metal nanowire has an aspect ratio $L/d$ of 10 to 1,000, the aspect ratio being a length $L$ to a diameter $d$ of a cross-section of the metal nanowire. Within the ranges, in even the low density of the nanowire, the network with the high conductivity, and also the transparent conductor with the low sheet resistance may be achieved. For example, the aspect ratio may be 500 to 1,000, for example, 500 to 700.

The metal nanowire may have a diameter (d) of a cross-section of more than 0 nm to 100 nm or less. Within the ranges, due to the high L/d, the transparent conductor with the high conductivity and the low sheet resistance may be achieved. For example, the diameter may be 30 nm to 100 nm, for example, 60 nm to 100 nm.

The metal nanowire may have a length (L) of not less than 20 $\mu$m. Within the ranges, due to the high L/d, the transparent conductor with the high conductivity and the low sheet resistance may be achieved. For example, the length may be 20 $\mu$m to 50 $\mu$m.

The metal nanowire may include the nanowire prepared from any suitable metal. For example, the metal nanowire may include the nanowire prepared from silver, copper, gold, or a mixture thereof. Illustratively, the nanowire may be prepared from silver or silver containing mixture.

The metal nanowire may be prepared by any suitable method typically used in the art, or may be a commercially available product. For example, the metal nanowire may be synthesized by reduction of a metal salt (for example, silver nitrate, $AgNO_3$) in the presence of polyol and polyvinylpyrrolidone. Alternatively, the metal nanowire may include the product commercially available from Cambrios Technologies Corporation (for example, ClearOhm™ ink, a solution comprising the metal nanowire).

The first transparent conductive film 120 may include not less than 13 wt%, for example, 13 wt% to 23 wt% of the metal nanowire. Within the ranges, the first transparent conductive film may have the sufficient conductivity, and form the conductive network.

The binder may be contained in the metal nanowire layer composition, the overcoat layer composition, or the transparent conductive film composition. The binder may include one or more of a monomer and an oligomer having a curable functional group (for example, a (meth)acrylate group). In one embodiment, the binder may include one or more of an urethane (meth)acrylate oligomer, a (meth)acrylate based monofunctional or a (meth)acrylate based multifunctional monomer.

The (meth)acrylate based monofunctional or (meth)acrylate based multifunctional monomer may include (meth)acrylic monomer having a functionality of not less than 1, for example, 1 to 6, such as (meth)acrylate having linear alkyl group of 1 carbon atoms to 20 carbon atoms, (meth)acrylate having branched alkyl group of 3 carbon atoms to 20 carbon atoms (meth)acrylate having hydroxyl group of 1 carbon atoms to 20 carbon atoms, (meth)acrylate having cycloaliphatic group of 3 carbon atoms to 20 carbon atoms, multifunctional (meth)acrylate having multivalent alcohol of 3 to 20 carbon atoms, and a mixtures thereof.

For example, the (meth)acrylate based monofunctional monomer may include, but not limited to, isobornyl (meth)acrylate, cyclopentyl (meth)acrylate, cyclohexyl (meth)acrylate or the like.

For example, the (meth)acrylate based multifunctional monomer may include, but not limited to, trimethylolpropane di(meth)acrylate, trimethylolpropane tri(meth)acrylate, ditrimethylolpropane tetra(meth)acrylate, pentaerythritol tri(meth)acrylate, pentaerythritol tetra(meth)acrylate, tris(2-hydroxyethyl)isocyanurate tri(meth)acrylate, glycerol tri(meth)acrylate, ethylene glycol di(meth)acrylate, neopentylglycol di(meth)acrylate, hexanediol di(meth)acrylate, dipentaerythritol penta(meth)acrylate, dipentaerythritol hexa(meth)acrylate, cyclodecane dimethanol di(meth)acrylate or the like.

The initiator may be any suitable initiator without limitation, as long as it absorbs a light at an absorption wavelength of 150 nm to 500 nm to induce a photoreaction. For example, the initiator may include phosphine oxide initiators, $\alpha$-hydroxyketone initiators or the like. For example, the initiator may include bis-acyl-phosphine oxide, diphenyl (2,4,6-trimethylbenzoyl) phosphine oxide, 1-hydroxycyclohexylphenylketone or a mixture thereof.

The additive may include thickeners, dispersants or the like, and may be included in a solution comprising the metal nanowire (for example, ClearOhm™ ink available from Cambrios Technologies Corporation) to provide the metal nanowire.

The solvent may include a main solvent and a co-solvent. The main solvent may include water, acetone and the like, and the co-solvent may include alcohols, such as methanol and the like for the miscibility of water and acetone.

In one embodiment, the first transparent conductive film 120 may be a cured product of composition comprising 13 wt% to 23 wt% of the metal nanowire, 75 wt% to 85 wt% of the binder, and 1 wt% to 3 wt% of the initiator based on the total weights of solids. Within the ranges, an effect of reducing the number of processes may be achieved with a single coating.

In another embodiment, the first transparent conductive film 120 may be a cured product of composition comprising 13 wt% to 23 wt% of the metal nanowire, 75 wt% to 85 wt% of the binder and the additive, and 1 wt% to 3 wt% of the initiator based on the total weights of solids. Within the ranges, an effect of reducing the number of processes may be achieved with a single coating.

The first transparent conductive film 120 may have a thickness of 10 nm to 1 $\mu$m, for example, 50 nm to 500 nm, more specifically 100 nm to 200 nm. Within the ranges, the first transparent conductor may be used as a film for touch panels.

Hereinafter, embodiments of the present invention will be described with reference to Fig. 2. The Fig. 2 illustrates a cross-sectional view of a transparent conductor according to another embodiment of the present invention. Referring to Fig. 2 a transparent conductor 100 according to another embodiment of the present invention may include a base layer 110, a first transparent conductive film 120 formed on an upper side of the base layer 110 and a further first transparent conductive film 120 may formed on a lower side of the base layer 110. wherein the base layer 110 may be a retardation film. In Fig. 2, the transparent conductor is substantially the same as the transparent conductor according to the embodiment of the invention in Fig. 1 except a second transparent conductive film is further formed on a lower side of the base layer.

Referring to Fig. 3, a transparent conductor according to other embodiment of the present invention is described hereinafter. Referring to Fig. 3, a transparent conductor 100' according to other embodiment of the present invention may include a base layer 110, a first transparent conductive film 120 formed on an upper side of the base layer 110, and a second transparent conductive film 130 formed on a lower side of the base layer 110, wherein the base layer 110 may be a retardation film. In Fig. 3, the transparent conductor is substantially the same as the transparent conductor according to the embodiment of the invention in Fig. 1 except a second transparent conductive film is further formed on a lower side of the base layer.

The second transparent conductive film 130 may be formed on the other side of the base layer 110 which has the first transparent conductive film 120 on one side. Thus, the second transparent conductive film 130 may be increasingly support the base layer 110. The second transparent conductive film 130 may embody conductivity by including a conductive material. The conductive material may include a carbon-nanotube, or a mixture of metal nanowire and a conductive polymer. The conductive polymer may include a PEDOT(poly(3,4-ethylenedioxythiophene), PEDOT:PSS(poly(3,4-ethylenedioxythiophene:polystyrenesulfonate) or the like.

In one example, the thickness of the second transparent conductive film 130 may be the same as or different from that of the first transparent conductive film 120. In one implement, the thickness of the second transparent conductive film 130 may be the same as that of the first transparent conductive film 120, to achieve the same resistance after patterning. Specifically, the thickness of the second transparent conductive film 130 may be 10 nm to 1 $\mu$m, 50nm to 500nm, or 100nm to 200nm.

Hereinafter, an apparatus of the embodiments will be described in detail. An apparatus according to one embodiment of the present invention may include the transparent conductor according to one embodiment of the present invention or a patterned form thereof. For example, the apparatus may include, but not limited to, optical display apparatuses, E-papers, or solar cells. The optical display apparatuses may include a touch panels, a touch screen panels, a flexible displays or the like.

Hereinafter, an optical display apparatuses according to embodiments of the present invention will be described with reference to Fig. 5 to Fig. 7. Figs. 5 to 7 are cross-sectional views of optical display apparatuses according to embodiments of the present invention.

Referring to Fig. 5, an optical display apparatus 200 of the embodiments may include a transparent electrode assembly 230 comprising a base layer 110, first and second electrodes 255, 260 on an upper side of the base layer 110, and third and fourth electrodes 265, 270 on a lower side of the base layer 110; a window 205 over an upper side of the first and second electrodes 255, 260; a first polarizing plate 235 over a lower side of the third and fourth electrodes 265, 270; a COLOR FILTER (CF) 240 on a lower side of the first polarizing plate 235; a panel 245 comprising a thin film transistor (TFT) on a lower side of the CF 240; and a second polarizing plate 250 on a lower side of the TFT 245. The transparent electrode assembly 230 may be manufactured by patterning the transparent conductor of another embodiment or the transparent conductor of one embodiment which further includes the first transparent conductive film formed on the low side of the base layer.

The transparent electrode assembly 230may be prepared by patterning the first and second transparent conductive films 120, 130, respectively using a given method (e.g., etching, or the like) to form first electrode 255, second electrode 260, third electrode 265 and fourth electrode 270. In addition, the base layer 110 may be a retardation film, and thus have an effect of compensating viewing angles, for example, for light transmitted through the second polarizing plate 250, the CF 240, the TFT 245, and the first polarizing plate 235.

The first and second electrodes 255, 260 may be Rx electrodes, and the third and fourth electrodes 265, 270 may be Tx electrodes, or vice versa.

The window 205 may perform a screen display function in the optical display apparatus and may be prepared from any suitable glass material or plastic film. The first and second polarizing plates 235, 250 may polarize external or internal light to impart polarization capabilities to the optical display apparatus, and may include a polarizer, or a laminate of a polarizer and a protective film. In addition, the polarizer and the protective film may include any one commonly used in the field of the polarizing plate.

Adhesive films 210, 212 may be placed between the window 205 and the transparent electrode assembly 230, and between the transparent electrode assembly 230 and the first polarizing plate 235, respectively, thereby maintaining the adhesion among the transparent electrode assembly 230, the window 205, and the first polarizing plate 235. The adhesive films 210, 212 may be any suitable adhesive films commonly used in the art, for example, optical clear adhesive (OCA) films.

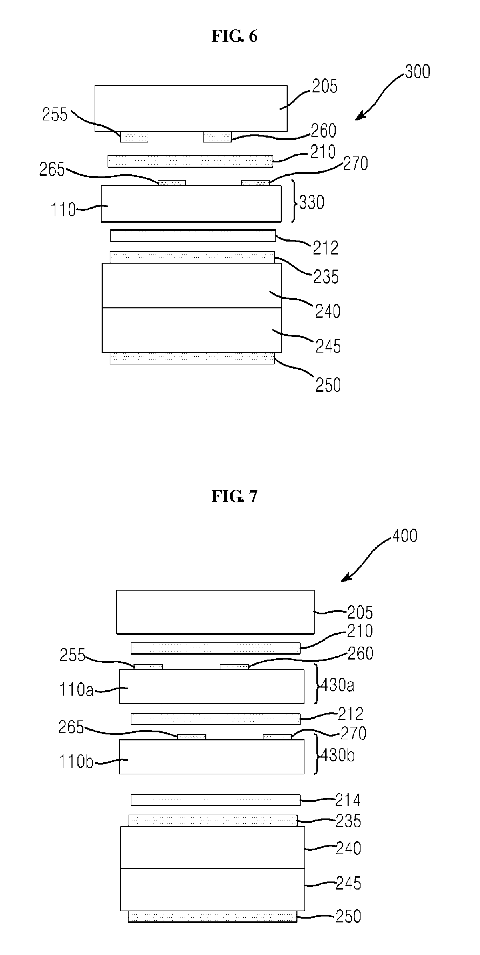

Referring to Fig. 6, an optical display apparatus 300 of another embodiment may include a transparent electrode assembly 330 comprising a base layer 110, and third and fourth electrodes 265, 270 on an upper side of the base layer 110. The optical display apparatus 300 may further include a window 205, having first and second electrodes 255, 260 on a lower side thereof, and formed over an upper side of the third and fourth electrodes 265, 270; a first polarizing plate 235 over a lower side of the transparent electrode assembly 330; a COLOR FILTER (CF) 240 on a lower side of the first polarizing plate 235; a panel 245 comprising a thin film transistor (TFT) on a lower side of the CF 240; and a second polarizing plate 250 on a lower side of the TFT 245. The transparent electrode assembly 330 may be manufactured by patterning the transparent conductor of one embodiment. The embodiment may be the same as the apparatus of one embodiment of this invention, but except that the transparent electrode assembly was manufactured by patterning the transparent conductor of one embodiment and the first and second electrodes are formed on a low side of the window.

The transparent electrode assembly 330 may be prepared by patterning the first transparent conductive film 120 in the transparent conductor in Fig. 1 using a given method to form third and fourth electrodes 265, 270. In addition, the base layer 110 may be a retardation film, and thus have an effect of compensating viewing angles, for example, for light transmitted through the second polarizing plate 250, the CF 240, the TFT 245, and the first polarizing plate 235. The first and second electrodes 255, 260 may be formed by using any suitable method commonly used for forming electrodes.

Referring to Fig. 7, an optical display apparatus 400 of further embodiment may include a first transparent electrode assembly 430a comprising a first base layer 110a, and first and second electrodes 255, 260 on an upper side of the first base layer 110a. The optical display apparatus 400 may further include a second transparent electrode assembly 430b on a lower side of the first transparent electrode assembly 430a comprising a second base layer 110b, and third and fourth electrodes 265, 270 on an upper side of the second base layer 110b; a first polarizing plate 235 on a lower side of the second transparent electrode assembly 430b; a COLOR FILTER (CF) 240 on a lower side of the first polarizing plate 235; a thin film transistor (TFT) 245 on a lower side of the CF 240; and a second polarizing plate 250 on a lower side of the TFT 245. The first transparent electrode assembly 430a and the second transparent electrode assembly 430b may be manufactured by patterning the transparent conductor of one embodiment. This embodiment may be the same as the apparatus of one embodiment of this invention, but except that the transparent electrode assembly was prepared by patterning the transparent conductor of one embodiment laminated as an adhesive film.

The first and second transparent electrode assemblies 430a, 430b are prepared by patterning the first transparent conductive film 120 in the transparent conductor in Fig. 1 using a given method to form the first, second, third, and fourth electrodes. In addition, the base layer may be a retardation film, and thus have an effect of compensating viewing angles, for example, for light transmitted through the second polarizing plate 250, the CF 240, the TFT 245, and the first polarizing plate 235.

Adhesive films 210, 212, 214 may be placed between the first transparent electrode assembly 430a and the window 205, between the first transparent electrode assembly 430a and the second transparent electrode assembly 430b, and among the second transparent electrode assembly 430b and the first polarizing plate 235, respectively, thereby maintaining the adhesion among the transparent electrode assemblies, the window, and the first polarizing plate.

The adhesive films 210, 212, 214 may be any suitable adhesive films commonly used in the art, for example, optical clear adhesive (OCA) films. In addition, although not illustrated in Figs. 4 to 6, the first base layers, the second base layers or the base layers may also include laminates having resin films stacked via adhesives or the like.

Hereinafter, the construction and functionality of the present invention will be described in more detail with reference to preferred Examples of the present invention. However, it should be noted that these Examples are provided for preferred illustration of the present invention, and are not construed in any way as limiting the present invention.

Details of components used in the Examples and Comparative Examples are set out in Table 1:

**Table 1**

| Materials | | Manufacturers | Product Names | Details |
|---|---|---|---|---|
| Base layer 1 | Retardation PC film | Teijin Chemical | WRS-148 | Polycarbonate film having a $\lambda/4$ retardation, thickness: 50 $\mu$m |
| Base layer 2 | Retardation COP film | Zeon | ZM16-138 | Cyclic olefin polymer film having a $\lambda/4$ retardation, thickness: 50 $\mu$m |
| Base layer 3 | HC PET film | Kimoto | 100CBP | Hard coated polyethylene terephthalate film with no retardation |
| Base layer 4 | HC COP film | Zeon | ZF14-050 | Hard coated cyclic olefin polymer film with no retardation |
| Solution containing metal nanowires | | Cambrios | Clear Ohm ink | Comprising silver nanowire, binder, thickener and dispersant. |
| Binder | | Sartomer | SR506A | - |
| | | SK Cytec | TMPTA | - |
| Initiator | | CIBA | IRG-184 | - |

**Example 1**

A metal nanowire layer composition was prepared by adding 50 parts by weight of a solution containing metal nanowires (for example, Clearohm™ ink, comprising total 1.65 wt% of the metal nanowires and the binders (metal nanowire: binder = 1: 1.65 by weight ratio), 1 wt% or less of thickeners, dispersants and the like, and solvents) to 50 parts by weight of a pure distillated water while stirring. An overcoat layer composition was prepared by adding 0.5 parts by weight of SR506A, 0.5 parts by weight of TMPTA, and 0.05 parts by weight of IRG-184 to 99 parts by weight of acetone. The metal nanowire layer composition was coated on a base layer 1 using a Meyer Bar #18 coating method. The composition was dried at 80 °C for 120 seconds and baked at 140 °C for 120 seconds in an oven. The overcoat layer composition was coated on the resulting metal nanowire layer using a Meyer Bar #18 coating method, dried at 80 °C for 120 seconds and baked at 120 °C for 120 seconds in an oven. Then, the resulting overcoat layer was subjected to UV curing under a metal halide lamp at 500 mJ/cm$^2$ in a nitrogen atmosphere to form a transparent conductor comprising a transparent conductive film consisting the metal nanowire layer comprising a cured product of the metal nanowires, the binders and the initiators on the base layer 1, and the overcoat layer comprising a cured product of the binders and the initiators.

**Example 2 and Comparative Examples 1 and 2**

In those Examples, a transparent conductor was prepared by the same method as described above except the base layers in Example 1 were replaced with those in Table 2.

The transparent conductor of Example and Comparative Examples was evaluated for the physical properties below. The results are set out in Table 2.

<Evaluation Method>

(1) Sheet resistance ($\Omega/\square$): After 10 seconds contacting 4-Pin probe of a contact-type sheet resistance tester MCP-T610 (available from Mitsubish Chemical Analytech Co., Ltd.) with a surface of the transparent conductive film of the transparent conductor, a sheet resistance was measured with the R-check (a contact resistance of the 4-Pin probe).

(2) Haze and total transmittance (%): With a surface of the transparent conductive film disposed to face a light source, a haze value and a total transmittance of the transparent conductor were measured using a haze meter (NDH-9000) at a wavelength of 400 nm to 700 nm.

(3) Optical property: nx, ny and nz values of the transparent conductor were measured and calculated by using AxoScan(Axometrics, Inc.).

Table 2

| | Types of base layers | Sheet resistance ($\Omega/\square$) | Haze value (%) | Total light transmittance (%) | Optical properties | | | B/A | C/A |
|---|---|---|---|---|---|---|---|---|---|
| | | | | | R0 (nm) at wavelength of 550 nm(A) | R0 (nm) at awavelength of 450 nm(B) | R0 (nm) at awavelength of 650 nm (C) | | |
| Example 1 | Base layer 1 | 50~60 | 1.04 | 90.27 | 142.52 | 128.628 | 145.37 | 0.90 | 1.02 |
| Example 2 | Base layer 2 | 50~60 | 1.12 | 90.22 | 136.23 | 144.40 | 138.95 | 1.06 | 1.02 |
| Comparative Example 1 | Base layer 3 | 50~60 | 0.90 | 90.92 | 0.808 | 0.678 | 2.084 | 0.84 | 2.58 |
| Comparative Example 2 | Base layer 4 | 50~60 | 1.09 | 90.25 | 119.11 | 103.62 | 179.85 | 0.87 | 1.51 |

* B/A: a ratio of a Ro value B in nm at a wavelength of 450 nm to a Ro value A in nm at a wavelength of 550 nm for the transparent conductor.
* C/A: a ratio of a Ro value C in nm at a wavelength of 650 nm to a Ro value A in nm at a wavelength of 550 nm for the transparent conductor.

In table 2, it may be seen that the transparent conductor of the present invention had *B/A* and *C/A* values within the ranges of the present invention, thus achieving an effect of compensating viewing angles and increasing visibility when applied to displays.

Accordingly, the transparent conductor of the present invention may achieve transparency, conductivity and an effect of compensating viewing angles, and also increase viewing angles caused by the increased area of optical display apparatuses.

On the other hand, the transparent conductors of Comparative Examples 1 and 2 in which the base layers were not retardation films couldn't achieve an effect of compensating viewing angles by having *B/A* and *C/A* values out of the ranges of the embodiments, and couldn't increase visibility when applied to displays.

It will be understood by those skilled in the art that the simple modifications or changes of the present invention may be made without departing from the spirit and scope of the present invention.

**Claims**

1. A transparent conductor comprising:

   a base layer; and
   a transparent conductive film formed on one or both sides of the base layer, the transparent conductive film comprising a metal nanowire,
   wherein the base layer is a retardation film.

2. The transparent conductor according to claim 1, wherein the transparent conductor has a *B/A* of 0.9 to 1.1, the *B/A* being a ratio of a *Ro* value *B* in nm at a wavelength of 450 nm to a *Ro* value A in nm at a wavelength of 550 nm, wherein the Ro is defined by Formula 1:

$$[\text{Formula 1}]$$

$$Ro = (nx - ny) \times d$$

   wherein Formula 1, nx and ny are refractive indexes in the x-axis of the transparent conductor and in the y-axis of the transparent conductor, respectively, and d is a thickness of the transparent conductor in nm.

3. The transparent conductor according to any one of claim 1 or 2, wherein the transparent conductor has a *C/A* of 0.9 to 1.1, the *C/A* being a ratio of a *Ro* value C in nm at a wavelength of 650 nm to a *Ro* value A in nm at a wavelength of 550 nm, wherein the Ro is defined by Formula 1:

$$[\text{Formula 1}]$$

$$Ro = (nx - ny) \times d$$

   wherein Formula 1, nx and ny are refractive indexes in the x-axis of the transparent conductor and in the y-axis of the transparent conductor, respectively, and d is a thickness of the transparent conductor in nm.

4. The transparent conductor according to any one of claims 1 to 3, wherein the transparent conductor has a Ro of 135 nm to 155 nm at a wavelength of 550 nm, wherein the Ro is defined by Formula 1:

$$[\text{Formula 1}]$$

$$Ro = (nx - ny) \times d$$

wherein Formula 1, nx and ny are refractive indexes in the x-axis of the transparent conductor and in the y-axis of the transparent conductor, respectively, and d is a thickness of the transparent conductor in nm

**5.** The transparent conductor according to any one of claims 1 to 4, wherein the transparent conductor has a thickness of 10 $\mu$m to 250 $\mu$m.

**6.** The transparent conductor according to any one of claims 1 to 5, wherein the transparent conductor has a $\lambda/4$ retardation or a $\lambda/2$ retardation.

**7.** The transparent conductor according to any one of claims 1 to 6, wherein the base layer is a $\lambda/2$ retardation film or a $\lambda/4$ retardation film.

**8.** The transparent conductor according to any one of claims 1 to 7, wherein the base layer is selected from polycarbonate, cyclic olefin, polyester, non-cyclic olefin, polysulfone, polyimide, silicone, polystyrene, polyacryl, or polyvinyl chloride films.

**9.** The transparent conductor according to any one of claims 1 to 8, wherein one or more of a hard coating layer, an anti-corrosive layer, an anti-glare coating layer, an adhesion promoter, and a coating layer for preventing the elution of an oligomer are further stacked on the one or both sides of the base layer.

**10.** The transparent conductor according to any one of claims 1 to 9, wherein the metal nanowire is a silver nanowire.

**11.** The transparent conductor according to any one of claims 1 to 10, wherein the metal nanowire has an aspect ratio $L/d$ of 10 to 1,000, the aspect ratio being a ratio of a length $L$ to a diameter d of a cross-section of the metal nanowire.

**12.** The transparent conductor according to any one of claims 1 to 11, wherein the metal nanowire is present in an amount of not less than 13 wt% in the transparent conductive film.

**13.** The transparent conductor according to any one of claims 1 to 12, wherein the transparent conductive film comprises a metal nanowire layer comprising a cured product of the metal nanowire, a binder and an initiator, and an overcoat layer comprising a cured product of the binder and the initiator on the metal nanowire layer.

**14.** The transparent conductor according to any one of claims 1 to 13, wherein the transparent conductive film comprises a cured product of the metal nanowire, a binder and an initiator.

**15.** The transparent conductor according to any one of claims 1 to 14, wherein the binder comprises one or more of an urethane (meth)acrylate oligomer, and a (meth)acrylate based monofunctional or multifunctional monomer.

**16.** The transparent conductor according to any one of claims 1 to 15, wherein the transparent conductive film comprises a cured product of a composition comprising 13 wt% to 23 wt% of the metal nanowire, 75 wt% to 85 wt% of the binder, and 1 wt% to 3 wt% of the initiator.

**17.** The transparent conductor according to any one of claims 1 to 16, wherein the base layer has a thickness of 50 $\mu$m to 150 $\mu$m, and the transparent conductive film has a thickness of 10 nm to 1 $\mu$m.

**18.** The transparent conductor according to any one of claims 1 to 17, wherein the transparent conductor has a Ro of 120 nm to 150 nm at a wavelength of 450 nm, 135 nm to 155 nm at a wavelength of 550 nm, 130 nm to 155 nm at a wavelength of 650 nm,
wherein the Ro is defined by Formula 1:

[Formula1]

$$Ro = (nx - ny) \times d$$

wherein Formula 1, nx and ny are refractive indexes in the x-axis of the transparent conductor and in the y-axis of the transparent conductor, respectively, and d is a thickness of the transparent conductor in nm.

**19.** An optical display apparatus comprising the transparent conductor according to any one of claims 1 to 18.

**FIG. 1**

100

120

110

**FIG. 2**

100

120

110

120

**FIG. 3**

100'

120

110

130

FIG. 4

FIG. 5

**FIG. 6**

**FIG. 7**

Europäisches
Patentamt

European
Patent Office

Office européen
des brevets

## EUROPEAN SEARCH REPORT

Application Number

EP 14 17 9164

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2012/046702 A1 (SHARP KK [JP]; ABIRU MANABU; KIDA KAZUTOSHI; YAMAGISHI SHINJI) 12 April 2012 (2012-04-12) | 1-12, 17-19 | INV. C08K3/08 G02F1/1343 |
| Y | * abstract; claims 1-4; figures 1-8 * | 13-16 | G02B5/30 |
| X,P | -& US 2013/222317 A1 (ABIRU MANABU [JP] ET AL) 29 August 2013 (2013-08-29) * paragraphs [0055] - [0121]; figures 1-9 * | 1-12, 17-19 | H01B1/22 |
| X,P | DATABASE WPI Week 201359 Thomson Scientific, London, GB; AN 2013-M32344 XP002730940, -& WO 2013/118643 A1 (KONICA MINOLTA INC) 15 August 2013 (2013-08-15) * abstract; claims 1,4,7; figure 5; examples 1,2 * | 1-17,19 | |
| Y | WO 2012/161899 A1 (CARESTREAM HEALTH INC [US]; ECKERT KARISSA L [US]; STEBBINS MATTHEW T) 29 November 2012 (2012-11-29) * page 3, line 31 - page 5, line 32 * | 13-16 | TECHNICAL FIELDS SEARCHED (IPC) C08K G02F |
| Y | US 2012/031460 A1 (HOSOYA YOICHI [JP] ET AL) 9 February 2012 (2012-02-09) * paragraphs [0073] - [0079], [0184] - [0183] * | 13-16 | G02B H01B |

The present search report has been drawn up for all claims

| Place of search | Date of completion of the search | Examiner |
|---|---|---|
| Munich | 14 October 2014 | Meiners, Christian |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

**ANNEX TO THE EUROPEAN SEARCH REPORT
ON EUROPEAN PATENT APPLICATION NO.**

EP 14 17 9164

This annex lists the patent family members relating to the patent documents cited in the above-mentioned European search report.
The members are as contained in the European Patent Office EDP file on
The European Patent Office is in no way liable for these particulars which are merely given for the purpose of information.

14-10-2014

| Patent document cited in search report | | Publication date | Patent family member(s) | | Publication date |
|---|---|---|---|---|---|
| WO 2012046702 | A1 | 12-04-2012 | US | 2013222317 A1 | 29-08-2013 |
| | | | WO | 2012046702 A1 | 12-04-2012 |
| US 2013222317 | A1 | 29-08-2013 | US | 2013222317 A1 | 29-08-2013 |
| | | | WO | 2012046702 A1 | 12-04-2012 |
| WO 2013118643 | A1 | 15-08-2013 | NONE | | |
| WO 2012161899 | A1 | 29-11-2012 | TW | 201303907 A | 16-01-2013 |
| | | | US | 2012301733 A1 | 29-11-2012 |
| | | | WO | 2012161899 A1 | 29-11-2012 |
| US 2012031460 | A1 | 09-02-2012 | CN | 102396078 A | 28-03-2012 |
| | | | JP | 2010251611 A | 04-11-2010 |
| | | | TW | 201044612 A | 16-12-2010 |
| | | | US | 2012031460 A1 | 09-02-2012 |
| | | | WO | 2010119912 A1 | 21-10-2010 |

EPO FORM P0459

For more details about this annex : see Official Journal of the European Patent Office, No. 12/82